# EUROPEAN PATENT APPLICATION

(11) **EP 4 633 070 A1**
(43) Date of publication of application: **15.10.2025**
(21) Application number: 23915742.3
(22) Date of filing: 05.12.2023
(51) Int. Cl.: H04L 1/00

(54) **DATA TRANSMISSION METHOD AND APPARATUS, DEVICE, SYSTEM, AND STORAGE MEDIUM**

(30) Priority: 13.01.2023 CN 202310200011; 31.01.2023 CN 202310119761
(71) Applicant: Huawei Technologies Co., Ltd., Shenzhen, Guangdong 518129 (CN)
(72) Inventor: HE, Xiang, Shenzhen, Guangdong 518129 (CN); WANG, Xinyuan, Shenzhen, Guangdong 518129 (CN)
(74) Representative: Huawei European IPR
(86) International application number: PCT/CN2023/136552
(87) International publication number: WO 2024/148984

(57) **Abstract**

This application discloses a data transmission method and apparatus, a device, a system, and a storage medium, and pertains to the communication field. The method includes: obtaining first data obtained by encoding first reference data by using a first FEC code; encoding the first data by using a second FEC code, to obtain a first encoding result; obtaining second data, where the second data includes the first encoding result and padding data used to adjust a frequency, the padding data carries data transmission related information, and the padding data is data on which protection processing is performed; and transmitting the second data. In the method, the padding data is protected, to improve reliability and efficiency of transmitting the padding data, so that the data transmission related information carried in the padding data can be transmitted more reliably.

## Description

This application claims priorities to Chinese Patent Application No. 202310200011.3, filed on January 13, 2023 and entitled "METHOD FOR IMPROVING RELIABILITY OF IN-BAND MANAGEMENT (OAM) COMMUNICATION", and further to Chinese Patent Application No. 202310119761.8, filed on January 31, 2023 and entitled "DATA TRANSMISSION METHOD AND APPARATUS, DEVICE, SYSTEM, AND STORAGE MEDIUM", both of which are incorporated herein by reference in their entireties.

### TECHNICAL FIELD

This application relates to the communication field, and in particular, to a data transmission method and apparatus, a device, a system, and a storage medium.

### BACKGROUND

In the communication field, a transmission rate of the Ethernet over a physical link is usually selected as an integer multiple of a frequency of a crystal oscillator. During data transmission, when concatenated coding is performed, if an overhead ratio of inner-code coding cannot support the integer multiple of the frequency, additional padding data usually needs to be added.

### SUMMARY

This application provides a data transmission method and apparatus, a device, a system, and a storage medium, to improve reliability and efficiency of transmitting padding data.

According to a first aspect, a data transmission method is provided. The method includes: obtaining first data, where the first data is obtained by encoding first reference data by using a first forward error correction (forward error correction, FEC) code; encoding the first data by using a second FEC code, to obtain a first encoding result; obtaining second data, where the second data includes the first encoding result and padding data used to adjust a frequency, the padding data carries data transmission related information, and the padding data is data on which protection processing is performed; and transmitting the second data.

In the method, the padding data is protected, to improve reliability and efficiency of transmitting the padding data, so that the data transmission related information carried in the padding data can be transmitted more reliably. The first FEC code and the second FEC code include but are not limited to any one of a Reed-Solomon (Reed-Solomon, RS) code, a Bose-Chaudhuri-Hocquenghem (Bose-Chaudhuri-Hocquenghem, BCH) code, a fire (fire) code, an extended BCH code, a Hamming code, an extended Hamming code, a turbo (turbo) code, a turbo product code (turbo product code, TPC), a staircase (staircase) code, and a low-density parity check (low-density parity check, LDPC) code.

In a possible implementation, the protection processing includes adding CRC, and the padding data is data to which protection of the CRC is added. If the protection of the CRC is added to the padding data, whether an error occurs in the padding data within a CRC protection range after transmission may be detected. To add a CRC function, a length of the padding data needs to be a length that causes the CRC to be insertable.

In a possible implementation, the protection processing includes performing encoding by using a third FEC code, and the padding data is data encoded by using the third FEC code. The FEC code can be used to not only detect an error, but also correct a bit error, thereby reducing a packet loss rate. The padding data is encoded by using the third FEC code, so that reliability can be further improved after the padding data is calculated by using the third FEC code.

In a possible implementation, the protection processing includes adding cyclic redundancy check (cyclic redundancy check, CRC) and performing encoding by using a third FEC code, and the padding data is data to which protection of the CRC is added and encoded by using the third FEC code. This protection manner may be applied to a scenario in which there is a high reliability requirement on the carried data transmission related information. In addition, the CRC needs to be first added, and the encoding is then performed by using the third FEC code. In this order, FEC protection may be performed on CRC content. If an error occurs in the CRC content, the error can also be corrected, so that reliability and efficiency of transmitting the padding data are further improved.

In a possible implementation, the third FEC code is the same as the second FEC code. When the third FEC code is the same as the second FEC code, an encoder and a decoder of the second FEC code that are already implemented are reused as much as possible.

In a possible implementation, a length of the padding data is an integer multiple of a length of the second FEC code. Therefore, a boundary of the second FEC can be fixed.

In a possible implementation, obtaining second data includes: inserting, into the first encoding result based on a reference density, the padding data used to adjust a frequency, to obtain the second data, where the reference density is determined based on overhead ratios of the first FEC code and the second FEC code and a frequency that is of a crystal oscillator and that is used when the first data is encoded by using the second FEC code.

In a possible implementation, after transmitting the second data, the method further includes: obtaining at least one piece of third data, where the third data is obtained by encoding second reference data by using a fourth FEC code; encoding any one of the at least one piece of third data by using a fifth FEC code, to obtain a second encoding result; obtaining fourth data, where the fourth data includes the second encoding result and padding data; and transmitting the fourth data.

At least one piece of fourth data is transmitted, and the fourth data and the second data each include the padding data, so that the same padding data can be transmitted a plurality of times. In this way, a receiver can determine, in a majority voting (majority voting) manner, whether correct padding data is received, to obtain the reliable data transmission related information.

According to a second aspect, a data transmission method is provided. The method includes: receiving second data, where the second data includes a first encoding result and padding data used to adjust a frequency, the padding data carries data transmission related information, the padding data is data on which protection processing is performed, the first encoding result is obtained by encoding first data by using a second FEC code, and the first data is obtained by encoding first reference data by using a first FEC code; obtaining the first encoding result and the padding data from the second data; decoding the first encoding result by using the second FEC code, to obtain the first data; and obtaining the data transmission related information based on the padding data.

In a possible implementation, the protection processing includes adding CRC, and the padding data is data to which protection of the CRC is added. Obtaining the data transmission related information based on the padding data includes: performing the CRC on the padding data, and obtaining the data transmission related information after the CRC succeeds.

In a possible implementation, the protection processing includes performing encoding by using a third FEC code, and the padding data is data encoded by using the third FEC code. Obtaining the data transmission related information based on the padding data includes: decoding the padding data by using the third FEC code, and obtaining the data transmission related information based on a decoding result.

In a possible implementation, the protection processing includes adding CRC and performing encoding by using a third FEC code, and the padding data is data to which protection of the CRC is added and encoded by using the third FEC code. Obtaining the data transmission related information based on the padding data includes: decoding the padding data by using the third FEC code, performing the CRC on a decoding result, and obtaining the data transmission related information after the CRC succeeds.

In a possible implementation, the third FEC code is the same as the second FEC code.

In a possible implementation, a length of the padding data is an integer multiple of a length of the second FEC code.

In a possible implementation, the method further includes: receiving at least one piece of fourth data, where the fourth data includes a second encoding result and padding data, the second encoding result is obtained by encoding third data by using a fifth FEC code, and the third data is obtained by encoding second reference data by using a fourth FEC code; obtaining the second encoding result and the padding data from each piece of fourth data; and decoding the second encoding result by using the fifth FEC code, to obtain the third data. Obtaining the data transmission related information based on the padding data includes: comparing, by a second module, the padding data obtained from each piece of fourth data with the padding data obtained from the second data, and when it is determined, based on a comparison result, that an amount of same padding data reaches a threshold, obtaining the data transmission related information based on the padding data.

In a possible implementation, comparing the padding data obtained from each piece of fourth data with the padding data obtained from the second data includes: separately splitting the padding data obtained from each piece of fourth data and the padding data obtained from the second data, and comparing data blocks obtained through splitting. A process of comparison between padding data is implemented by comparing the data blocks, to improve comparison efficiency.

According to a third aspect, a data transmission apparatus is provided. The apparatus includes: a first obtaining module, configured to obtain first data, where the first data is obtained by encoding first reference data by using a first FEC code; an encoding module, configured to encode the first data by using a second FEC code, to obtain a first encoding result; a second obtaining module, configured to obtain second data, where the second data includes the first encoding result and padding data used to adjust a frequency, the padding data carries data transmission related information, and the padding data is data on which protection processing is performed; and a transmission module, configured to transmit the second data.

In a possible implementation, the protection processing includes adding CRC, and the padding data is data to which protection of the CRC is added.

In a possible implementation, the protection processing includes performing encoding by using a third FEC code, and the padding data is data encoded by using the third FEC code.

In a possible implementation, the protection processing includes adding CRC and performing encoding by using a third FEC code, and the padding data is data to which protection of the CRC is added and encoded by using the third FEC code.

In a possible implementation, the third FEC code is the same as the second FEC code.

In a possible implementation, a length of the padding data is an integer multiple of a length of the second FEC code.

In a possible implementation, the second obtaining module is configured to insert, into the first encoding result based on a reference density, the padding data used to adjust a frequency, to obtain the second data, where the reference density is determined based on overhead ratios of the first FEC code and the second FEC code and a frequency that is of a crystal oscillator and that is used when the first data is encoded by using the second FEC code.

In a possible implementation, the first obtaining module is further configured to obtain at least one piece of third data, where the third data is obtained by encoding second reference data by using a fourth FEC code; the encoding module is further configured to encode any one of the at least one piece of third data by using a fifth FEC code, to obtain a second encoding result; the second obtaining module is further configured to obtain fourth data, where the fourth data includes the second encoding result and padding data; and the transmission module is further configured to transmit the fourth data.

According to a fourth aspect, a data transmission apparatus is provided. The apparatus includes: a receiving module, configured to receive second data, where the second data includes a first encoding result and padding data used to adjust a frequency, the padding data carries data transmission related information, the padding data is data on which protection processing is performed, the first encoding result is obtained by encoding first data by using a second FEC code, and the first data is obtained by encoding first reference data by using a first FEC code; a first obtaining module, configured to obtain the first encoding result and the padding data from the second data; a decoding module, configured to decode the first encoding result by using the second FEC code, to obtain the first data; and a second obtaining module, configured to obtain the data transmission related information based on the padding data.

In a possible implementation, the protection processing includes adding CRC, and the padding data is data to which protection of the CRC is added; and the second obtaining module is configured to: perform the CRC on the padding data, and obtain the data transmission related information after the CRC succeeds.

In a possible implementation, the protection processing includes performing encoding by using a third FEC code, and the padding data is data encoded by using the third FEC code; and the second obtaining module is configured to: decode the padding data by using the third FEC code, and obtain the data transmission related information based on a decoding result.

In a possible implementation, the protection processing includes adding CRC and performing encoding by using a third FEC code, and the padding data is data to which protection of the CRC is added and encoded by using the third FEC code; and the second obtaining module is configured to: decode the padding data by using the third FEC code, perform the CRC on a decoding result, and obtain the data transmission related information after the CRC succeeds.

In a possible implementation, the third FEC code is the same as the second FEC code.

In a possible implementation, a length of the padding data is an integer multiple of a length of the second FEC code.

In a possible implementation, the receiving module is further configured to receive at least one piece of fourth data, where the fourth data includes a second encoding result and padding data, the second encoding result is obtained by encoding third data by using a fifth FEC code, and the third data is obtained by encoding second reference data by using a fourth FEC code; the first obtaining module is further configured to obtain the second encoding result and the padding data from each piece of fourth data; the decoding module is further configured to decode the second encoding result by using the fifth FEC code, to obtain the third data; and the second obtaining module is configured to: compare the padding data obtained from each piece of fourth data with the padding data obtained from the second data, and when it is determined, based on a comparison result, that an amount of same padding data reaches a threshold, obtain the data transmission related information based on the padding data.

In a possible implementation, the second obtaining module is configured to: separately split the padding data obtained from each piece of fourth data and the padding data obtained from the second data, and compare data blocks obtained through splitting.

According to a fifth aspect, a network device is provided. The network device includes a processor. The processor is coupled to a memory, the memory stores at least one program instruction or code, and the at least one program instruction or code is loaded and executed by the processor, to enable the network device to implement the method according to either of the first aspect or the second aspect.

According to a sixth aspect, a data transmission system is provided. The system includes a first module and a second module. The first module is configured to perform the method according to any one of the first aspect, and the second module is configured to perform the method according to any one of the second aspect.

According to a seventh aspect, a computer-readable storage medium is provided. The storage medium stores at least one program instruction or code, and when the program instruction or code is loaded and executed by a processor, a computer is enabled to implement the method according to either of the first aspect or the second aspect.

According to an eighth aspect, a chip is provided, and includes a processor. The processor is configured to implement the method according to either of the first aspect or the second aspect.

According to a ninth aspect, a communication device is further provided. The communication device includes the chip according to the eighth aspect.

According to a tenth aspect, a computer program (product) is provided, and includes a computer program or code. When the computer program or code is executed by a computer, the computer is enabled to perform the method according to either of the first aspect or the second aspect.

According to an eleventh aspect, another communication apparatus is provided. The apparatus includes a transceiver, a memory, and a processor. The transceiver, the memory, and the processor communicate with each other through an internal connection path. The memory is configured to store instructions. The processor is configured to execute the instructions stored in the memory, to control the transceiver to receive a signal and control the transceiver to send a signal, and when the processor executes the instructions stored in the memory, the processor is enabled to perform the method in any one of the first aspect or the possible implementations of the first aspect, or perform the method in any one of the second aspect or the possible implementations of the second aspect.

In an example embodiment, there are one or more processors, and there are one or more memories.

In an example embodiment, the memory may be integrated with the processor, or the memory and the processor are separately disposed.

During specific implementation, the memory may be a non-transitory (non-transitory) memory, such as a read-only memory (read-only memory, ROM). The memory and the processor may be integrated on one chip, or may be separately disposed on different chips. A type of the memory and a manner in which the memory and the processor are disposed are not limited in embodiments of this application.

According to a twelfth aspect, a chip is provided, and includes a processor, configured to: invoke, from a memory, instructions stored in a memory and run the instructions, to enable a communication device on which the chip is installed to perform the methods in the foregoing aspects.

According to a thirteenth aspect, another chip is provided, and includes an input interface, an output interface, a processor, and a memory. The input interface, the output interface, the processor, and the memory are connected through an internal connection path. The processor is configured to execute code in the memory. When the code is executed, the processor is configured to perform the methods in the foregoing aspects.

It should be understood that for beneficial effects achieved by the technical solutions in the second aspect to the thirteenth aspect and the corresponding possible implementations in embodiments of this application, refer to the technical effects of the first aspect and the corresponding possible implementations. Details are not described herein again.

### BRIEF DESCRIPTION OF DRAWINGS

FIG. 1 is a diagram of a process of concatenated coding according to an embodiment of this application;
FIG. 2 is a diagram of an implementation scenario according to an embodiment of this application;
FIG. 3 is an interaction diagram of a data transmission method according to an embodiment of this application;
FIG. 4 is a diagram of inserting padding data according to an embodiment of this application;
FIG. 5 is a diagram of a structure of padding data according to an embodiment of this application;
FIG. 6 is a diagram of a structure of padding data according to an embodiment of this application;
FIG. 7 is a diagram of a structure of a data transmission apparatus according to an embodiment of this application;
FIG. 8 is a diagram of a structure of a data transmission apparatus according to an embodiment of this application;
FIG. 9 is a diagram of a structure of a communication device according to an embodiment of this application;
FIG. 10 is a diagram of a structure of a communication device according to an embodiment of this application; and
FIG. 11 is a diagram of a structure of a communication device according to an embodiment of this application.

### DESCRIPTION OF EMBODIMENTS

Terms used in implementations of this application are merely used to explain embodiments of this application, but are not intended to limit this application. The following describes embodiments of this application with reference to the accompanying drawings.

With development of communication technologies, data transmission manners are increasing, and data transmission over an Ethernet link is one of the data transmission manners. During data transmission, a transmission rate of the Ethernet over a physical link is usually selected as an integer multiple of a frequency of a crystal oscillator. In an Ethernet interface using forward error correction (forward error correction, FEC) encoding, FEC overhead selection also complies with a rule that a transmission rate is usually selected as an integer multiple of a frequency of a crystal oscillator. An FEC code includes but is not limited to any one of a Reed-Solomon (Reed-Solomon, RS) code, a Bose-Chaudhuri-Hocquenghem (Bose-Chaudhuri-Hocquenghem, BCH) code, a fire (fire) code, an extended BCH code, a Hamming code, an extended Hamming code, a turbo (turbo) code, a turbo product code (turbo product code, TPC), a staircase (staircase) code, and a low-density parity check (low-density parity check, LDPC) code.

For example, a frequently-used crystal oscillator frequency (also referred to as a fundamental frequency) of the Ethernet is 156.25 megahertz (megahertz, MHz), 312.5 MHz, or the like. An RS code is used as an example. For a 100 GbE with RS (528, 514), in 100GBASE-KR4, a rate on each physical lane is 25.78125 gigabits per second (gigabit per second, Gbps or Gb/s) under non-return-to-zero (non-return-to-zero, NRZ) code modulation, and a transmission baud rate is 165 times the fundamental frequency 156.25 MHz. For another example, for a 400 GbE with RS (544, 514), in 400GBASE-DR4, a rate on each physical lane is 106.25 Gb/s under 4-level (or 4-stage) pulse amplitude modulation (4-level pulse amplitude modulation, PAM4) modulation, and a baud rate is 53.125 GBd, and is 340 times the fundamental frequency 156.25 MHz.

In addition, in discussion on the institute of electrical and electronics engineers (Institute of Electrical and Electronics Engineers, IEEE) 802.3 Ethernet interface standard, a 200G/lane (lane) intensity-modulation direct-detection (intensity-modulation direct-detection, IMDD) optical link may use concatenated FEC (concatenated FEC). For example, a host application-specific integrated circuit (host application-specific integrated circuit, host ASIC) chip provides an RS (544, 514) code. After performing a specific integration operation on a data stream without decoding, an optical module further superimposes a short code for encoding. The short code may be any type of FEC code. A concatenated code may alternatively be all integrated into, for example, the hostASIC chip. When concatenated coding is performed, the concatenated FEC includes an outer code and an inner code. An example in which the outer code is a first FEC code, and the inner code is a second FEC code is used. During the concatenated coding, it is considered that an overhead selection of the inner code (the second FEC code) can also support an integer multiple of the fundamental frequency. k represents an information bit length of the second FEC code, and n represents a second FEC codeword length, where k and n are positive integers, and values of k and n are related to a code pattern.

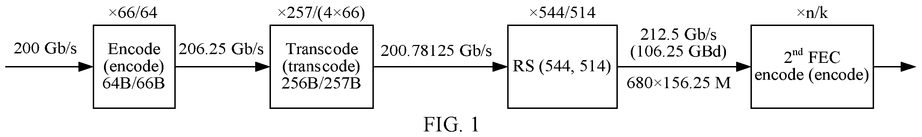

FIG. 1 is a diagram of a process of concatenated coding. For example, after 64-bit (bit, B)/66B encoding, a transmission rate marked as 200G/lane is 206.25 Gb/s, and a transmission rate after transcoding to 256B/257B encoding is 200.78125 Gb/s. Based on RS (544, 514), an actual transmission rate marked as 200G/lane is 212.5 Gb/s, and when PAM4 modulation is used, a baud rate is 106.25 GBd. In this case, if encoding with an overhead ratio n/k=18/17 is used on this basis, a physical link rate can be increased to 225 Gb/s, namely, 112.5 GBd (a baud rate of 112.5G), and is 720 times the fundamental frequency. When an overhead ratio of the second FEC code cannot support an integer multiple of the frequency, additional padding (pad or padding) data usually needs to be added, to increase the rate to a nearest integer multiple of the frequency. For example, if the overhead ratio of second FEC encoding is n/k=16/15, the foregoing transmission baud rate 106.25 GBd is increased to 113.333... GBd, which is no longer an integer multiple of the fundamental frequency. If 1/1088 padding data is added, a final rate is adjusted to 726 times the fundamental frequency, that is, 113.4375 GBd. An operation of second FEC encoding is shown in 2^{nd} FEC encoding in FIG. 1.

Although the addition of the additional padding data causes the physical link rate to be further increased, even if the padding data accounts for a very low ratio (for example, 1/1088, about 0.09%), bandwidth waste occurs for a system with a severely limited bandwidth. Therefore, the padding data may be used to carry data transmission related information, to use such a bandwidth part. The data transmission related information is not limited in embodiments of this application. For example, the data transmission related information may be some management and control information, and the management and control information includes but is not limited to: adjusting optical device parameters, adjusting electrical characteristic parameters of optical modules, exchanging signal receiving/sending quality with a peer end, and negotiating a switch of an FEC interleaver.

Regardless of which type of data transmission related information is carried in the padding data, an error may also occur in a transmission process of the padding data due to a bit error ratio. Refer to the following Table 1. A relationship between a length of padding data and a bit error-free transmission probability in a case of a bit error ratio (bit error ratio, BER) of 4.5×10⁻³ is listed.

**Table 1**

| Length of padding data | Probability of correct transmission (BER=4.5 × 10⁻³) |
|---|---|
| 32 | 86.6% |
| 64 | 74.9% |
| 128 | 56.1% |
| 256 | 31.5% |

It can be easily learned from Table 1 that a larger length of the padding data indicates a lower probability of correct transmission of the padding data. If the padding data is used to carry the data transmission related information, as the probability of the correct transmission decreases, reliability of correctly transmitting the data transmission related information is not high. An embodiment of this application provides a data transmission method. In the method, padding data is protected, to improve reliability of transmitting the padding data, so that data transmission related information carried in the padding data can be transmitted more reliably.

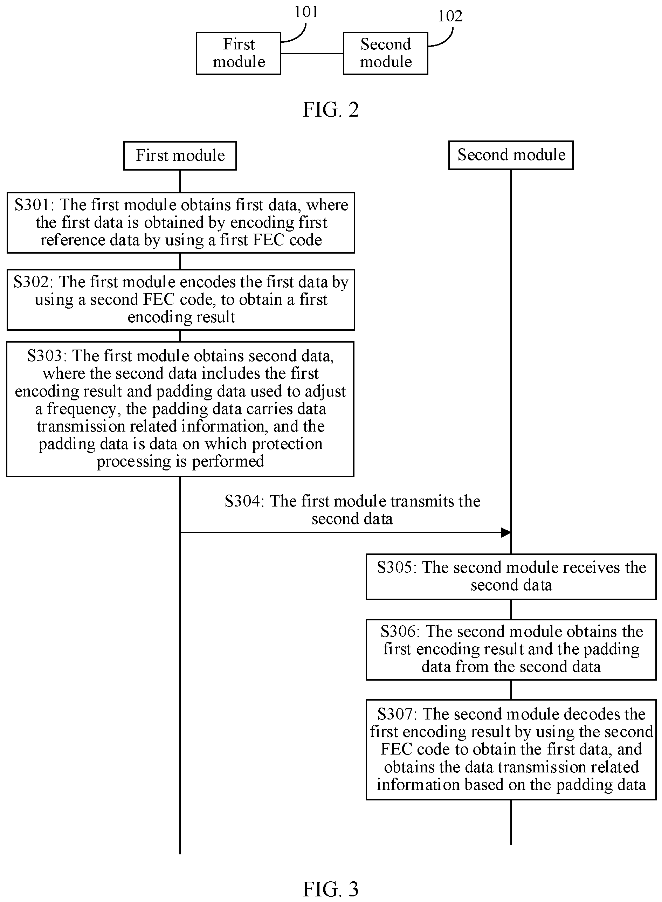

FIG. 2 is a diagram of an implementation scenario of a data transmission method according to an embodiment of this application. Refer to FIG. 2. The implementation scenario includes a first module 101 and a second module 102, and the first module 101 and the second module 102 are communicatively connected. For example, the first module 101 and the second module 102 are communicatively connected over a plurality of physical links. For example, the first module 101 is included in a first device, and the second module 102 is included in a second device; or the first module 101 and the second module 102 may be included in a same device. A device in which any one or both of the first module 101 and the second module 102 are located may be a network device, or may be another device that includes an Ethernet interface or complies with the IEEE 802.3 standard. In addition, the implementation scenario shown in FIG. 2 may further include another module. This is not limited in this embodiment of this application.

The data transmission method provided in this embodiment of this application may be shown in FIG. 3. An example in which the first module performs the method is used, and S301 to S304 below are included.

S301: The first module obtains first data, where the first data is obtained by encoding first reference data by using a first FEC code.

In this embodiment of this application, a manner in which the first module obtains the first data may be as follows: After obtaining the first reference data, the first module encodes the first reference data by using the first FEC code to obtain the first data. In this manner, the first module is a source node for data transmission.

In a possible implementation, a manner in which the first module obtains the first data may alternatively be as follows: After encoding the first reference data by using the first FEC code to obtain the first data, another module other than the first module sends the first data to the first module, so that the first module obtains the first data. In this case, the first module may be an intermediate node for data transmission. Optionally, before encoding the first reference data by using the first FEC code, the first module or the another module may further scramble the first reference data.

Regardless of whether the first module encodes the first reference data by using the first FEC code or the another module encodes the first reference data by using the first FEC code, the first FEC code includes but is not limited to any one of an RS code, a BCH code, a fire code, an extended BCH code, a Hamming code, an extended Hamming code, a turbo code, a TPC code, a staircase code, and an LDPC code.

In addition, in addition to being obtained by encoding the first reference data by using the first FEC code, the first data may alternatively be obtained through other processing. A processing manner of the other processing is not limited in embodiments of this application. For example, the first data is data that is obtained by encoding the first reference data by using the first FEC code and through a physical medium attachment (physical medium attachment sublayer, PMA) sublayer and/or a physical media dependent (physical media dependent, PMD) layer interface, or the first data is data obtained by performing encoding by using the first FEC code and through interleaving processing and a PMA and/or a PMD. The interleaving processing may be performed a plurality of times. For example, the first data is obtained by performing encoding by using the first FEC code, through interleaving processing and the PMA and/or the PMD, then through interleaving processing, and then through aggregation.

S302: The first module encodes the first data by using a second FEC code, to obtain a first encoding result.

The first data is re-encoded by using the second FEC code, so that quality of data transmission can be improved. The second FEC code is not limited in embodiments of this application, and includes but not limited to any one of an RS code, a BCH code, a fire code, an extended BCH code, a Hamming code, an extended Hamming code, a turbo code, a TPC code, a staircase code, and an LDPC code. In a possible implementation, the used second FEC code may be auto-negotiated between the first module and a second module that receives data. An auto-negotiation process may be performed after the first module obtains the first data, or may be performed before the method is performed. An occasion of the auto-negotiation is not limited in this embodiment of this application.

In addition, as described in S301, if the first data is data that is sent by the another module, that is received by the first module, and that is obtained through scrambling, when the first module encodes the first data by using the second FEC code, the first module removes a scrambling code of the first data, and encodes, by using the second FEC code, data obtained by removing the scrambling code, to obtain the first encoding result. The data obtained by removing the scrambling code is still the data obtained by performing encoding by using the first FEC code.

S303: The first module obtains second data, where the second data includes the first encoding result and padding data used to adjust a frequency, the padding data carries data transmission related information, and the padding data is data on which protection processing is performed.

As described above, when a concatenated code is used for encoding, it is also considered that overhead selection of an inner code (the second FEC code) can also support an integer multiple of a fundamental frequency. When an overhead ratio of the second FEC code cannot support the integer multiple of the frequency, additional padding (pad or padding) data usually needs to be added, to increase a rate to the integer multiple of the frequency. Therefore, in the method provided in this embodiment of this application, the second data may be obtained by inserting the padding data into the first encoding result, and the padding data may be used to adjust the frequency.

In a possible implementation, that the first module obtains second data includes: The first module inserts, into the first encoding result based on a reference density, the padding data used to adjust a frequency, to obtain the second data. Determining of the reference density includes but is not limited to determining based on overhead ratios of the first FEC code and the second FEC code and a frequency that is of a crystal oscillator and that is used when the first data is encoded by using the second FEC code. That is, a frequency that is of the crystal oscillator and that is used for determining the reference density is the frequency that is of the crystal oscillator and that is used when the first module encodes the first data by using the second FEC code.

In this embodiment of this application, the reference density of inserting the padding data may also be referred to as a proportion of inserting the padding data. An example in which the second FEC code is an extended Hamming code (128, 120), and the reference density of inserting the padding data is 1/m is used. For the extended Hamming code (128, 120), n=128, and k=120. Because a rate on a 200G/lane physical lane after encoding performed by using the first FEC code, namely, an RS (544, 514) code is 212.5 Gb/s, and is 106.25 GBd under PAM4 modulation, an input signal on which encoding is performed by using the second FEC code is at 680 multiplying the frequency. In this case, 680*n/k*(1+m)/m=Z needs to be satisfied, where Z is an integer. To save bandwidth as much as possible, Z=┌680*n/k┐. That is, 680*n/k is rounded up to obtain a value of Z. Optionally, Z may alternatively be an integer greater than ┌680*n/k┐.

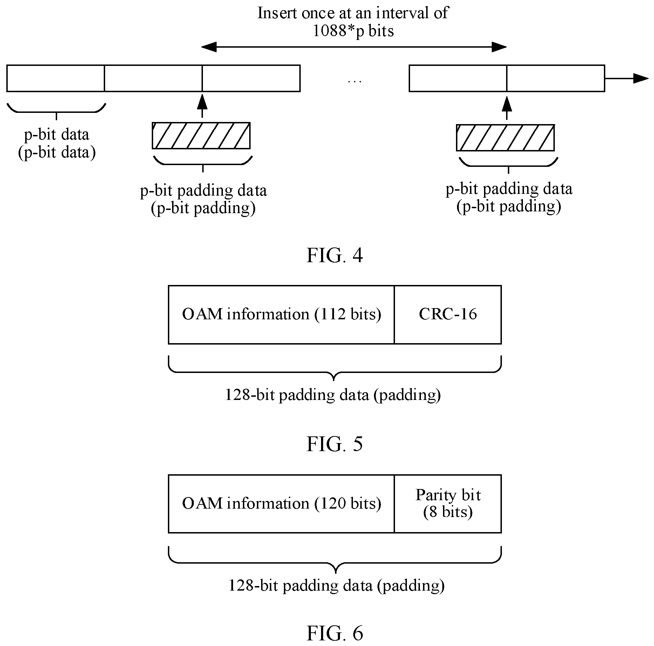

680*n/k=725.333.... Therefore, closest Z is equal to 726. Then, m=1088 may be obtained through calculation, that is, the reference density (proportion) of inserting the padding data is 1/1088. As shown in FIG. 4, p bits are inserted at an interval of 1088*p bits. p is a length of the inserted padding data. The length of the padding data is not limited in embodiments of this application, provided that the reference density (proportion) of inserting the padding data meets a requirement of 1/m. For example, to fix a boundary of the second FEC, the length of the padding data may be an integer multiple of a length of the second FEC code.

Regardless of the reference density of inserting the padding data and the length of the padding data, the protection processing may be performed on the padding data in embodiments of this application, to improve transmission reliability of the padding data. A protection processing manner used for the padding data is not limited in embodiments of this application, and includes but is not limited to the following three manners.

Protection processing manner 1: The protection processing includes adding cyclic redundancy check (cyclic redundancy check, CRC), and the padding data is data to which protection of the CRC is added.

For the protection processing manner 1, to add a CRC function, the length p of the padding data needs to be a length that causes the CRC to be insertable. For example, if CRC-N is used, the length p needs to be at least N+1 bits. In this embodiment of this application, in consideration of efficiency, the length p of the padding data may be 2N or larger, and N may be a positive integer greater than or equal to 3. To fix the boundary of the second FEC code, the length p of the padding data is an integer multiple of the length n of the second FEC codeword. Therefore, the length of the padding data needs to cause the CRC to be insertable and needs to be the integer multiple of the length n of the second FEC codeword.

The CRC is a check mechanism, and is used to detect whether an error occurs in data (including a parity bit) within a CRC protection range after transmission. If the protection of the CRC is performed on the padding data, whether an error occurs in the padding data within the CRC protection range after transmission may be detected. CRC-n indicates that a length of a parity bit is n bits (bits). For a parity bit with a same length, namely, n bits, the parity bit may be generated in a plurality of calculation manners, and the calculation manner is determined using a polynomial corresponding to the CRC. A highest-degree item of a CRC-n polynomial is of order n. Different polynomials may have different check capabilities.

As shown in FIG. 5, for example, the length p of the padding data is equal to 128, and the padding data is protected by using CRC-16. The padding data on which protection processing is performed includes carried 112-bit (bits) operations, administration and maintenance (operations, administration and maintenance, OAM) information and a CRC-16 parity bit. There are many options for the CRC-16. In the data length range of 128-16=112 bits, a largest protectable Hamming distance HD is equal to 6. For example, a CRC polynomial 0x9eb2 is used, that is, x^16+x^13+x^12+x^11+x^10+x^8+x^6+x^5+x^2+1, namely, x¹⁶+x¹³+x¹²+¹¹+x¹⁰+ ⁸+ ⁶+ ⁵+x²+1. When a 5-bit error occurs within the 128-bit range, the CRC can ensure that the 5-bit error can be detected. In this case, information is received only when CRC on a receive side succeeds, so that a probability of correctly receiving information is greatly improved. In a case of a same BER of 4.5 × 10⁻³, a probability of six or more bit errors within the 128-bit range is 2.8×10⁻⁵. Compared with an error probability of 56.1%, reliability is improved by 20,000 times when the CRC-16 is added.

Protection processing manner 2: The protection processing includes performing encoding by using a third FEC code, and the padding data is data encoded by using the third FEC code.

The FEC code can be used to not only detect an error, but also correct a bit error, thereby reducing a packet loss rate. The padding data is encoded by using the third FEC code, so that reliability can be further improved after the padding data is calculated by using the third FEC code. The third FEC code is not limited in embodiments of this application, and includes but not limited to any one of an RS code, a BCH code, a fire code, an extended BCH code, a Hamming code, an extended Hamming code, a turbo code, a TPC code, a staircase code, and an LDPC code. In a possible implementation, the used third FEC code may be auto-negotiated between the first module and the second module that receives the data. An auto-negotiation process may be performed after the first module obtains the first encoding result, or may be performed before the method is performed. An occasion of the auto-negotiation is not limited in this embodiment of this application.

In the protection processing manner 2, the third FEC code used for the padding data may be the same as the second FEC code, or may be different from the second FEC code. In a data pipeline processing process, if the padding data is removed and does not enter a decoder of the second FEC code, the decoder of the second FEC code "misses a beat". To be specific, there is no data that needs to be processed in a clock cycle. Not only additional processing is needed, but also chip performance is wasted. In a possible implementation of this application, when the third FEC code is the same as the second FEC code, an encoder and the decoder of the second FEC code that are already implemented are reused as much as possible.

Regardless of whether the third FEC code is the same as the second FEC code, as shown in FIG. 6, an example in which the used third FEC code is an extended Hamming code (128, 120), and the length p of the padding data is equal to 128 is used. The padding data on which protection processing is performed includes carried 120-bit (bits) OAM information and an 8-bit parity bit. The 8-bit parity bit may use a parity (parity) code. If error correction on padding data obtained by adding FEC protection is performed on a receive side in a hard decision decoding manner, one bit error can be corrected. In this way, a correctness probability of each piece of padding data is increased from 56.1% to 88.6%. If a soft decision decoding manner is used for error correction, the correctness probability may be increased to more than 98%.

Protection processing manner 3: The protection processing includes adding CRC and performing encoding by using a third FEC code, and the padding data is data to which protection of the CRC is added and encoded by using the third FEC code.

The protection processing manner 3 is a combination of the protection processing manner 1 and the protection processing manner 2, and may be applied to a scenario in which there is a high reliability requirement on the carried data transmission related information. For example, it is required to satisfy that "mean operating time to first failure acceptance" (also referred to as mean time to false packet acceptance (mean time to false packet acceptance, MTTFPA))>1.3×10⁹ years, and a plurality of protection processing manners may need to be used to protect the padding data.

For the protection processing manner 3, the CRC needs to be first added, and the third FEC code is then used for encoding. In this order, FEC protection may be performed on CRC content. If an error occurs in the CRC content, the error can also be corrected, so that reliability and efficiency of transmitting the padding data are further improved. For example, the CRC protection is first performed on padding data, and FEC encoding is performed on the padding data such as the CRC content and OAM information. On the receive side, FEC error correction is first performed, and CRC is then performed.

S304: The first module transmits the second data.

A manner in which the first module transmits the second data to the second module is not limited in embodiments of this application. For example, the first module transmits the second data to the second module over a physical link. For another example, the first module transmits the second data through a logical lane, where the logical lane may be a physical coding sublayer (physical coding sublayer, PCS) lane or an FEC lane. For example, if there is one logical lane, the first module transmits the second data through the lane. If a quantity of logical lanes is a positive integer greater than or equal to 2, the first module may distribute the second data and then send the second data through a plurality of logical lanes.

S301 to S304 are described by using an example in which the first module performs the method. Next, a process in which the second module performs data transmission is used as an example, and the following S305 to S307 are included.

S305: The second module receives the second data.

The second data includes the first encoding result and the padding data used to adjust a frequency. For example, the second data is obtained by the first module by inserting, into the first encoding result, the padding data used to adjust a frequency. The padding data carries the data transmission related information, and the padding data is the data on which protection processing is performed. The first encoding result is obtained by encoding the first data by using the second FEC code, and the first data is obtained by encoding the first reference data by using the first FEC code.

A manner in which the second module receives the second data transmitted by the first module is not limited in embodiments of this application, provided that the manner corresponds to the manner in which the first module transmits the second data to the second module. For a manner of obtaining the second data, refer to the process of S301 to S304 above. Details are not described herein again.

S306: The second module obtains the first encoding result and the padding data from the second data.

The second data includes the first encoding result and the padding data. Therefore, after receiving the second data, the second module may separately obtain the first encoding result and the padding data from the second data. A manner in which the second module obtains the first encoding result and the padding data from the second data is not limited in embodiments of this application.

S307: The second module decodes the first encoding result by using the second FEC code to obtain the first data, and obtains the data transmission related information based on the padding data.

A manner in which the second module decodes the first encoding result by using the second FEC code is not limited in embodiments of this application. In addition, after obtaining the first encoding result and the padding data, the second module may first decode the first encoding result by using the second FEC code to obtain the first data, and then obtains the data transmission related information based on the padding data. Optionally, the second module may alternatively first obtain the data transmission related information based on the padding data, and then decode the first encoding result by using the second FEC code to obtain the first data. A sequence of obtaining the first data and obtaining the data transmission related information by the second module is not limited in embodiments of this application either.

The data transmission related information may be obtained based on the padding data based on a protection processing manner. Different protection processing manners include but are not limited to the following three obtaining manners of the data transmission related information.

Obtaining manner 1: The protection processing includes adding CRC, and the padding data is data to which protection of the CRC is added. That the second module obtains the data transmission related information based on the padding data includes: The second module performs the CRC on the padding data, and obtains the data transmission related information after the CRC succeeds.

When performing the CRC on the padding data, the second module may perform the CRC on the padding data by using a length of protection of the CRC added to the padding data. If the CRC succeeds, it indicates that no error occurs in the padding data, and the obtained data transmission related information is also accurate and reliable. In a possible implementation, when the second module performs CRC on the padding data, if the CRC fails, the second module may not obtain the data transmission related information, or obtain correct data transmission related information in another manner. A processing process after the CRC fails is not limited in this application.

Obtaining manner 2: The protection processing includes performing encoding by using a third FEC code, and the padding data is data encoded by using the third FEC code. That the second module obtains the data transmission related information based on the padding data includes: The second module decodes the padding data by using the third FEC code, and obtains the data transmission related information based on a decoding result.

For the obtaining manner 2, because the third FEC code may be determined by the first module and the second module through negotiation, the second module may determine to use the third FEC code when decoding the padding data. The third FEC code may be any type of FEC code. A process of decoding the padding data by using the third FEC code is not described in detail in this embodiment of this application.

Obtaining manner 3: The protection processing includes adding CRC and performing encoding by using a third FEC code, and the padding data is data to which protection of the CRC is added and encoded by using the third FEC code. That the second module obtains the data transmission related information based on the padding data includes: The second module decodes the padding data by using the third FEC code, performs the CRC on a decoding result, and obtains the data transmission related information after the CRC succeeds.

The obtaining manner 3 may be understood as an inverse process of the protection processing manner 3 in S303. The padding data may be first decoded by using the third FEC code to obtain the decoding result, and the CRC is then performed on the decoding result. If the CRC succeeds, the data transmission related information is obtained. Optionally, if the padding data fails to be decoded by using the third FEC code, a subsequent CRC operation may not be performed.

Reliability of the padding data in a transmission process is improved by protecting the padding data by adding the CRC, using FEC encoding protection on the padding data, or using a combination thereof. In addition, a manner of transmitting the same padding data a plurality of times is further supported in the method provided in this embodiment of this application, so that a receiver, namely, the second module, can determine, in a majority voting (majority voting) manner, whether correct padding data is received, to obtain reliable data transmission related information. In a possible implementation, after the first module transmits the second data, the method further includes: The first module obtains at least one piece of third data, where the third data is obtained by encoding second reference data by using a fourth FEC code; encodes any one of the at least one piece of third data by using a fifth FEC code, to obtain a second encoding result; obtains fourth data, where the fourth data includes the second encoding result and padding data; and transmits the fourth data.

When the fourth data is obtained, the fourth data may be obtained in a manner of inserting the padding data into the second encoding result. A quantity of the at least one piece of third data may be one or more. An amount of the third data obtained by the first module is not limited in embodiments of this application. If there are a plurality of pieces of third data, the first module may obtain the plurality of pieces of third data at different time, or may obtain the plurality of pieces of third data at the same time. A manner in which the first module obtains the third data is not limited in embodiments of this application. For details, refer to the manner in which the first data is obtained in S301.

In addition, the first reference data and the second reference data may be the same or may be different. The fourth FEC code and the fifth FEC code may be the same as the first FEC code, the second FEC code, or the third FEC code, or may be different from the first FEC code, the second FEC code, or the third FEC code. After one piece of third data is encoded by using the fifth FEC code, one second encoding result may be obtained. After padding data is inserted into the second encoding result, one piece of fourth data may be obtained. That is, the amount of the third data may be the same as an amount of the fourth data. The padding data inserted into the second encoding result may be the same as the padding data inserted into the first encoding result. That is, the same padding data is transmitted to the second module a plurality of times via the second data and the fourth data. The padding data inserted into the second encoding result is also on which protection processing is performed. For a manner of obtaining the padding data, refer to the related descriptions in S303. For a manner of transmitting the fourth data, refer to the related descriptions in S304. Details are not described herein again.

Correspondingly, the second module receives at least one piece of fourth data, where the fourth data includes the second encoding result and padding data, the second encoding result is obtained by encoding the third data by using the fifth FEC code, and the third data is obtained by encoding the second reference data by using the fourth FEC code; obtains the second encoding result and the padding data from each piece of fourth data; and decodes the second encoding result by using the fifth FEC code, to obtain the third data. In this case, that the second module obtains the data transmission related information based on the padding data includes: The second module compares the padding data obtained from each piece of fourth data with the padding data obtained from the second data, and when it is determined, based on a comparison result, that an amount of same padding data reaches a threshold, obtains the data transmission related information based on the padding data.

The threshold reached by the amount of same padding data is not limited in embodiments of this application. The threshold may be set based on experience, may be flexibly set based on an application scenario, or may be determined based on a quantity of times of sending the padding data. For example, the first module continuously sends the same padding data three times, and the second module determines whether two pieces of padding data are the same. If the two pieces of padding data are the same, the data transmission related information is obtained. If any two pieces of padding data are not the same, the received padding data is discarded

In a possible implementation, for long padding data, errors occur frequently under a high bit error ratio, and error positions are inconsistent. As a result, criteria may not be converged, and the padding data cannot be successfully received for long time. Therefore, in the method provided in this embodiment of this application, the long padding data can be split into small data blocks, and a process of comparison between padding data is implemented by comparison between data blocks, thereby improving comparison efficiency. For example, that the second module compares the padding data obtained from each piece of fourth data with the padding data obtained from the second data includes: The second module separately splits the padding data obtained from each piece of fourth data and the padding data obtained from the second data, and compares data blocks obtained through splitting. A granularity at which the second module splits the padding data is not limited in embodiments of this application. For example, the padding data may be split by byte, and comparison is performed byte by byte in a unit of each byte.

In conclusion, according to the technical solution provided in embodiments of this application, when concatenated coding is performed and the padding data needs to be inserted, the protection processing is performed on the padding data, so that reliability and efficiency of transmitting the padding data can be improved, and reliability of using the padding data to carry the data transmission related information is improved. In addition, the protection processing manners for the padding data are various, so that flexibility of protecting the padding data is improved, and adaptability is stronger. In addition, in embodiments of this application, the FEC code used to perform FEC encoding on the padding data is the same as an inner code in the concatenated coding, namely, the second FEC code. This can avoid a waste of chip performance. The length of the padding data is set to the integer multiple of the length of the second FEC code, so that the boundary of the second FEC code can be fixed.

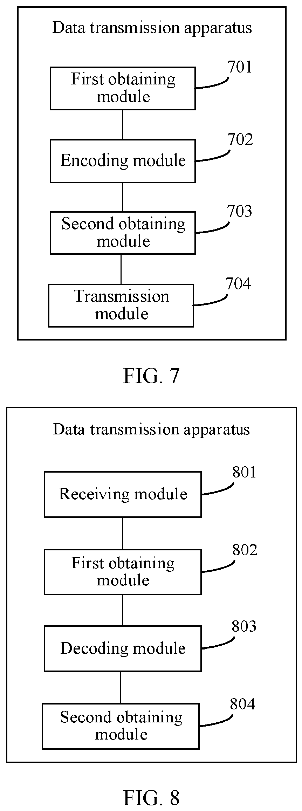

An embodiment of this application further provides a data transmission apparatus. FIG. 7 is a diagram of a structure of a data transmission apparatus according to an embodiment of this application. Based on a plurality of modules shown in FIG. 7, the data transmission apparatus shown in FIG. 7 can perform all or some of operations performed by the first module in the method embodiment shown in FIG. 3. It should be understood that the apparatus may include more additional modules than the shown modules or omit some of the shown modules. This is not limited in this embodiment of this application. As shown in FIG. 7, the apparatus includes:
a first obtaining module 701, configured to obtain first data, where the first data is obtained by encoding first reference data by using a first FEC code;
an encoding module 702, configured to encode the first data by using a second FEC code, to obtain a first encoding result;
a second obtaining module 703, configured to obtain second data, where the second data includes the first encoding result and padding data used to adjust a frequency, the padding data carries data transmission related information, and the padding data is data on which protection processing is performed; and
a transmission module 704, configured to transmit the second data.

In a possible implementation, the protection processing includes adding CRC, and the padding data is data to which protection of the CRC is added.

In a possible implementation, the protection processing includes performing encoding by using a third FEC code, and the padding data is data encoded by using the third FEC code.

In a possible implementation, the protection processing includes adding CRC and performing encoding by using a third FEC code, and the padding data is data to which protection of the CRC is added and encoded by using the third FEC code.

In a possible implementation, the third FEC code is the same as the second FEC code.

In a possible implementation, a length of the padding data is an integer multiple of a length of the second FEC code.

In a possible implementation, the second obtaining module 703 is configured to insert, into the first encoding result based on a reference density, the padding data used to adjust a frequency, to obtain the second data, where the reference density is determined based on overhead ratios of the first FEC code and the second FEC code and a frequency that is of a crystal oscillator and that is used when the first data is encoded by using the second FEC code.

In a possible implementation, the first obtaining module 701 is further configured to obtain at least one piece of third data, where the third data is obtained by encoding second reference data by using a fourth FEC code. The encoding module 702 is further configured to encode any one of the at least one piece of third data by using a fifth FEC code, to obtain a second encoding result. The second obtaining module 703 is further configured to obtain fourth data, where the fourth data includes the second encoding result and padding data. The transmission module 704 is further configured to transmit the fourth data.

An embodiment of this application further provides a data transmission apparatus. FIG. 8 is a diagram of a structure of a data transmission apparatus according to an embodiment of this application. Based on a plurality of modules shown in FIG. 8, the data transmission apparatus shown in FIG. 8 can perform all or some of operations performed by the second module in the method embodiment shown in FIG. 3. It should be understood that the apparatus may include more additional modules than the shown modules or omit some of the shown modules. This is not limited in this embodiment of this application. As shown in FIG. 8, the apparatus includes:
a receiving module 801, configured to receive second data, where the second data includes a first encoding result and padding data used to adjust a frequency, the padding data carries data transmission related information, the padding data is data on which protection processing is performed, the first encoding result is obtained by encoding first data by using a second FEC code, and the first data is obtained by encoding first reference data by using a first FEC code;
a first obtaining module 802, configured to obtain the first encoding result and the padding data from the second data;
a decoding module 803, configured to decode the first encoding result by using the second FEC code, to obtain the first data; and
a second obtaining module 804, configured to obtain the data transmission related information based on the padding data.

In a possible implementation, the protection processing includes adding CRC, and the padding data is data to which protection of the CRC is added. The second obtaining module 804 is configured to: perform the CRC on the padding data, and obtain the data transmission related information after the CRC succeeds.

In a possible implementation, the protection processing includes performing encoding by using a third FEC code, and the padding data is data encoded by using the third FEC code. The second obtaining module 804 is configured to: decode the padding data by using the third FEC code, and obtain the data transmission related information based on a decoding result.

In a possible implementation, the protection processing includes adding cyclic redundancy check CRC and performing encoding by using a third FEC code, and the padding data is data to which protection of the CRC is added and encoded by using the third FEC code. The second obtaining module 804 is configured to: decode the padding data by using the third FEC code, perform the CRC on a decoding result, and obtain the data transmission related information after the CRC succeeds.

In a possible implementation, the third FEC code is the same as the second FEC code.

In a possible implementation, a length of the padding data is an integer multiple of a length of the second FEC code.

In a possible implementation, the receiving module 801 is further configured to receive at least one piece of fourth data, where the fourth data includes a second encoding result and padding data, the second encoding result is obtained by encoding third data by using a fifth FEC code, and the third data is obtained by encoding second reference data by using a fourth FEC code. The first obtaining module 802 is further configured to obtain the second encoding result and the padding data from each piece of fourth data. The decoding module 803 is further configured to decode the second encoding result by using the fifth FEC code, to obtain the third data. The second obtaining module 804 is configured to: compare the padding data obtained from each piece of fourth data with the padding data obtained from the second data, and when it is determined, based on a comparison result, that an amount of same padding data reaches a threshold, obtain the data transmission related information based on the padding data.

In a possible implementation, the second obtaining module 804 is configured to: separately split the padding data obtained from each piece of fourth data and the padding data obtained from the second data, and compare data blocks obtained through splitting.

It should be understood that, when the apparatuses provided in FIG. 7 and FIG. 8 implement functions of the apparatuses, division into the foregoing functional modules is merely used as an example for description. During actual application, the foregoing functions may be allocated to different functional modules for completion based on a requirement. In other words, an inner structure of a device is divided into different functional modules, to complete all or some of the functions described above. In addition, the apparatuses provided in the foregoing embodiment and the method embodiments belong to a same concept. For a specific implementation process thereof, refer to the method embodiments. Details are not described herein again.

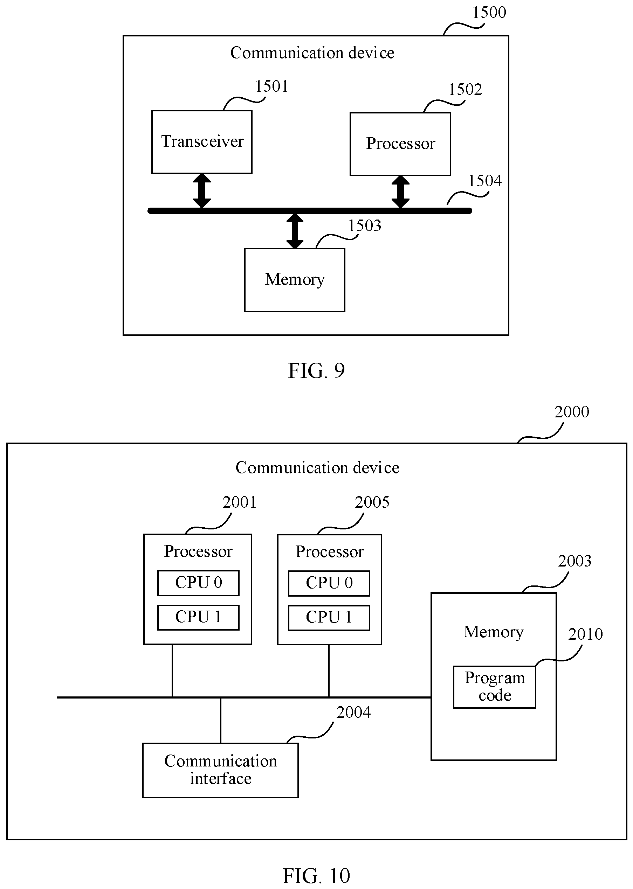

An embodiment of this application provides a communication device. A hardware structure of the communication device is a communication device 1500 shown in FIG. 9, and includes a transceiver 1501, a processor 1502, and a memory 1503. The transceiver 1501, the processor 1502, and the memory 1503 are connected by using a bus 1504. The transceiver 1501 is configured to: receive a packet and send a packet. The memory 1503 is configured to store instructions or program code. The processor 1502 is configured to invoke the instructions or the program code in the memory 1503, to enable the device to perform related processing steps of the first module or the second module in the foregoing method embodiments. In a specific embodiment, the communication device 1500 in this embodiment of this application may correspond to the first module or the second module in the foregoing method embodiments. The processor 1502 in the communication device 1500 reads the instructions or the program code in the memory 1503, to enable the communication device 1500 shown in FIG. 9 to perform all or some of operations performed by the first module or the second module.

The communication device 1500 may further correspond to the apparatus shown in FIG. 7 or FIG. 8. For example, the transmission module 704 and the receiving module 801 in FIG. 7 and FIG. 8 are equivalent to the transceiver 1501, and the first obtaining module 701, the encoding module 702, the second obtaining module 703, the first obtaining module 802, the decoding module 803, and the second obtaining module 804 are equivalent to the processor 1502.

FIG. 10 is a diagram of a structure of a communication device 2000 according to an example embodiment of this application. The communication device 2000 shown in FIG. 10 is configured to perform operations related to the data transmission method shown in FIG. 3. The communication device 2000 is, for example, a switch or a router.

As shown in FIG. 10, the communication device 2000 includes at least one processor 2001, a memory 2003, and at least one communication interface 2004.

The processor 2001 is, for example, a general-purpose central processing unit (central processing unit, CPU), a digital signal processor (digital signal processor, DSP), a network processor (network processor, NP), a graphics processing unit (Graphics Processing Unit, GPU), a neural network processing unit (neural network processing unit, NPU), a data processing unit (Data Processing Unit, DPU), a microprocessor, or one or more integrated circuits configured to implement the solutions of this application. For example, the processor 2001 includes an application-specific integrated circuit (Application-specific Integrated Circuit, ASIC), a programmable logic device (programmable logic device, PLD) or another programmable logic device, a transistor logic device, a hardware component, or any combination thereof. The PLD is, for example, a complex programmable logic device (complex programmable logic device, CPLD), a field-programmable gate array (field-programmable gate array, FPGA), a generic array logic (generic array logic, GAL), or any combination thereof. The processor may implement or execute various logical blocks, modules, and circuits described with reference to content disclosed in embodiments of the present invention. The processor may be a combination of processors implementing a computing function, for example, a combination of one or more microprocessors, or a combination of a DSP and a microprocessor.

Optionally, the communication device 2000 further includes a bus. The bus is configured to transfer information between components of the communication device 2000. The bus may be a peripheral component interconnect (peripheral component interconnect, PCI for short) bus, an extended industry standard architecture (extended industry standard architecture, EISA for short) bus, or the like. The bus may be classified into an address bus, a data bus, a control bus, and the like. For ease of representation, only one bold line is used to represent the bus in FIG. 10, but this does not mean that there is only one bus or only one type of bus. In addition to being connected by using the bus, the components of the communication device 2000 in FIG. 10 may be connected in another manner. A manner in which the components are connected is not limited in this embodiment of the present invention.

The memory 2003 is, for example, a read-only memory (read-only memory, ROM) or another type of static storage device that can store static information and instructions, or a random access memory (random access memory, RAM) or another type of dynamic storage device that can store information and instructions, or an electrically erasable programmable read-only memory (electrically erasable programmable read-only Memory, EEPROM), a compact disc read-only memory (compact disc read-only memory, CD-ROM) or another compact disc storage, an optical disc storage (including a compact disc, a laser disc, an optical disc, a digital versatile disc, a Blu-ray disc, and the like), a magnetic disk storage medium or another magnetic storage device, or any other medium that can be used to carry or store expected program code in a form of instructions or a data structure and that can be accessed by a computer, but is not limited thereto. For example, the memory 2003 exists independently, and is connected to the processor 2001 by using the bus. Alternatively, the memory 2003 and the processor 2001 may be integrated together.

The communication interface 2004 is any apparatus such as a transceiver, and is configured to communicate with another device or a communication network. The communication network may be the Ethernet, a radio access network (RAN), a wireless local area network (wireless local area network, WLAN), or the like. The communication interface 2004 includes a wired communication interface, and may further include a wireless communication interface. Specifically, the communication interface 2004 may be an Ethernet (Ethernet) interface, a fast Ethernet (Fast Ethernet, FE) interface, a Gigabit Ethernet (Gigabit Ethernet, GE) interface, an asynchronous transfer mode (Asynchronous Transfer Mode, ATM) interface, a wireless local area network (wireless local area network, WLAN) interface, a cellular network communication interface, or a combination thereof. The Ethernet interface may be an optical interface, an electrical interface, or a combination thereof. In this embodiment of this application, the communication interface 2004 may be used by the communication device 2000 to communicate with another device.

During specific implementation, in an embodiment, the processor 2001 may include one or more CPUs, for example, a CPU 0 and a CPU 1 in FIG. 10. Each of the processors may be a single-core processor (single-CPU) or may be a multi-core processor (multi-CPU). The processor herein may be one or more devices, circuits, and/or processing cores configured to process data (for example, computer program instructions).

During specific implementation, in an embodiment, the communication device 2000 may include a plurality of processors, for example, a processor 2001 and a processor 2005 shown in FIG. 10. Each of the processors may be a single-core processor (single-CPU) or may be a multi-core processor (multi-CPU). The processor herein may be one or more devices, circuits, and/or processing cores configured to process data (for example, computer program instructions).

During specific implementation, in an embodiment, the communication device 2000 may further include an output device and an input device. The output device communicates with the processor 2001, and may display information in a plurality of manners. For example, the output device may be a liquid crystal display (liquid crystal display, LCD), a light emitting diode (light emitting diode, LED) display device, a cathode ray tube (cathode ray tube, CRT) display device, or a projector (projector). The input device communicates with the processor 2001, and may receive an input of a user in a plurality of manners. For example, the input device may be a mouse, a keyboard, a touchscreen device, or a sensing device.

In some embodiments, the memory 2003 is configured to store program code 2010 for performing the solutions of this application, and the processor 2001 can execute the program code 2010 stored in the memory 2003. That is, the communication device 2000 may implement, by using the processor 2001 and the program code 2010 in the memory 2003, the packet method provided in the method embodiments. The program code 2010 may include one or more software modules. Optionally, the processor 2001 may alternatively store program code or instructions for executing the solutions of this application.

In a specific embodiment, the communication device 2000 in this embodiment of this application may correspond to the first module or the second module in the foregoing method embodiments. The processor 2001 in the communication device 2000 reads the program code 2010 in the memory 2003 or the program code or the instructions stored in the processor 2001, to enable the communication device 2000 shown in FIG. 10 to perform all or some of operations performed by the first module or the second module.

The communication device 2000 may further correspond to the apparatus shown in FIG. 7 or FIG. 8. Each functional module in the apparatus shown in FIG. 7 or FIG. 8 is implemented by using software of the communication device 2000. In other words, the functional module included in the apparatus shown in FIG. 7 or FIG. 8 is generated after the processor 2001 of the communication device 2000 reads the program code 2010 stored in the memory 2003. For example, the transmission module 704 and the receiving module 801 in FIG. 7 or FIG. 8 are equivalent to the communication interface 2004, and the first obtaining module 701, the encoding module 702, the second obtaining module 703, the first obtaining module 802, the decoding module 803, and the second obtaining module 804 are equivalent to the processor 2001 and/or the processor 2005.

The steps in the method shown in FIG. 3 are completed by using an integrated logic circuit of hardware in the processor of the communication device 2000 or by using instructions in a form of software. The steps in the methods disclosed with reference to embodiments of this application may be directly performed and completed by a hardware processor, or may be performed and completed by using a combination of hardware in the processor and a software module. The software module may be located in a mature storage medium in the art, such as a random access memory, a flash memory, a read-only memory, a programmable read-only memory, an electrically erasable programmable memory, or a register. The storage medium is located in the memory, and the processor reads information in the memory, and completes the steps in the foregoing methods in combination with the hardware in the processor. To avoid repetition, details are not described herein again.

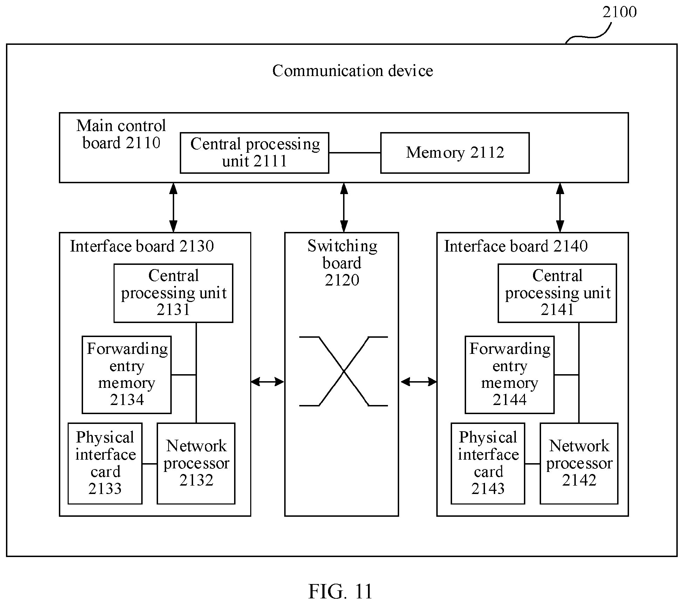

FIG. 11 is a diagram of a structure of a communication device 2100 according to another example embodiment of this application. The communication device 2100 shown in FIG. 11 is configured to perform all or some of operations in the method shown in FIG. 3. The communication device 2100 is, for example, a switch or a router, and the communication device 2100 may be implemented by using a general bus architecture.

As shown in FIG. 11, the communication device 2100 includes a main control board 2110 and an interface board 2130.

The main control board is also referred to as a main processing unit (main processing unit, MPU) or a route processing card (route processor card). The main control board 2110 is configured to: control and manage components in the communication device 2100, including functions of route computation, device management, device maintenance, and protocol processing. The main control board 2110 includes a central processing unit 2111 and a memory 2112.

The interface board 2130 is also referred to as a line processing unit (line processing unit, LPU), a line card (line card), or a service board. The interface board 2130 is configured to provide various service interfaces, and forward a data packet. The service interface includes but is not limited to an Ethernet interface, a POS (Packet over SONET/SDH) interface, and the like. The Ethernet interface is, for example, a flexible Ethernet service interface (Flexible Ethernet Clients, FlexE Clients). The interface board 2130 includes a central processing unit 2131, a network processor 2132, a forwarding entry memory 2134, and a physical interface card (physical interface card, PIC) 2133.

The central processing unit 2131 on the interface board 2130 is configured to: control and manage the interface board 2130 and communicate with the central processing unit 2111 on the main control board 2110.

The network processor 2132 is configured to send a packet. A form of the network processor 2132 may be a forwarding chip. The forwarding chip may be a network processor (network processor, NP). In some embodiments, the forwarding chip may be implemented by using an application-specific integrated circuit (application-specific integrated circuit, ASIC) or a field-programmable gate array (field-programmable gate array, FPGA). Specifically, the network processor 2132 is configured to: forward a received packet based on a forwarding table stored in the forwarding entry memory 2134. If a destination address of the packet is an address of the communication device 2100, the network processor sends the packet to a CPU (for example, the central processing unit 2131) for processing; or if a destination address of the packet is not an address of the communication device 2100, the network processor searches, based on the destination address, the forwarding table for a next hop and an outbound interface corresponding to the destination address, and forwards the packet to the outbound interface corresponding to the destination address. Processing of an uplink packet may include: processing of a packet ingress interface and forwarding table searching. Processing of a downlink packet may include: forwarding table searching, and the like. In some embodiments, the central processing unit may alternatively perform a function of the forwarding chip, for example, implement software forwarding based on a general-purpose CPU, so that the interface board does not need the forwarding chip.

The physical interface card 2133 is configured to implement a physical layer interconnection function. Original traffic enters the interface board 2130 from the physical interface card 2133, and a processed packet is sent out from the physical interface card 2133. The physical interface card 2133 is also referred to as a subcard and may be installed on the interface board 2130, and is responsible for converting an optical/electrical signal into a packet, performing validity check on the packet, and then forwarding the packet to the network processor 2132 for processing. In some embodiments, the central processing unit 2131 may alternatively perform a function of the network processor 2132, for example, implement software forwarding based on a general-purpose CPU, so that the physical interface card 2133 does not need the network processor 2132.

Optionally, the communication device 2100 includes a plurality of interface boards. For example, the communication device 2100 further includes an interface board 2140. The interface board 2140 includes a central processing unit 2141, a network processor 2142, a forwarding entry memory 2144, and a physical interface card 2143. Functions and implementations of components in the interface board 2140 are the same as or similar to those in the interface board 2130. Details are not described herein again.

Optionally, the communication device 2100 further includes a switching board 2120. The switching board 2120 may also be referred to as a switch fabric unit (switch fabric unit, SFU). When the communication device has a plurality of interface boards, the switching board 2120 is configured to complete data exchange between the interface boards. For example, the interface board 2130 and the interface board 2140 may communicate with each other by using the switching board 2120.

The main control board 2110 is coupled to the interface board. For example, the main control board 2110, the interface board 2130, the interface board 2140, and the switching board 2120 are connected to a system backboard by using a system bus for interworking. In a possible implementation, an inter-process communication (inter-process communication, IPC) protocol lane is established between the main control board 2110, the interface board 2130, and the interface board 2140, and the main control board 2110, the interface board 2130, and the interface board 2140 communicate with each other through the IPC lane.

Logically, the communication device 2100 includes a control plane and a forwarding plane. The control plane includes the main control board 2110 and the central processing unit 2111. The forwarding plane includes components that perform forwarding, such as the forwarding entry memory 2134, the physical interface card 2133, and the network processor 2132. The control plane performs the following functions: a function of a router, generating a forwarding table, processing signaling and a protocol packet, configuring and maintaining a communication device status, and the like. The control plane delivers the generated forwarding table to the forwarding plane. On the forwarding plane, the network processor 2132 searches the forwarding table delivered by the control plane, and then forwards, based on the table, a packet received by the physical interface card 2133. The forwarding table delivered by the control plane may be stored in the forwarding entry memory 2134. In some embodiments, the control plane and the forwarding plane may be completely separated, and are not on a same communication device.

It should be noted that, there may be one or more main control boards. When there are a plurality of main control boards, the main control boards may include a primary main control board and a secondary main control board. There may be one or more interface boards. A stronger data processing capability of the communication device indicates a larger quantity of provided interface boards. There may also be one or more physical interface cards on the interface board. There may be no switching board or one or more switching boards. When there are a plurality of switching boards, load balancing and redundancy backup may be implemented together. In a centralized forwarding architecture, the communication device may not need the switching board, and the interface board provides a function of processing service data of an entire system. In a distributed forwarding architecture, the communication device may have at least one switching board, and data exchange between a plurality of interface boards is implemented by using the switching board, to provide a large-capacity data exchange and processing capability. Therefore, a data access and processing capability of the communication device in the distributed architecture needs to be higher than that of the communication device in the centralized architecture. Optionally, the communication device may alternatively be in a form in which there is only one card. That is, there is no switching board, and functions of the interface board and the main control board are integrated on the card. In this case, the central processing unit on the interface board and the central processing unit on the main control board may be combined into one central processing unit on the card, to perform functions obtained by combining the two central processing units. The communication device in this form (for example, a communication device such as a low-end switch or router) has a weak data exchange and processing capability. A specific architecture that is to be used depends on a specific networking deployment scenario. This is not limited herein.

In a specific embodiment, the communication device 2100 corresponds to the apparatuses shown in FIG. 7 and FIG. 8. In some embodiments, the transmission module 704 and the receiving module 801 in the apparatuses shown in FIG. 7 and FIG. 8 are equivalent to the physical interface card 2133 or the physical interface card 2143 in the communication device 2100. The first obtaining module 701, the encoding module 702, the second obtaining module 703, the first obtaining module 802, the decoding module 803, and the second obtaining module 804 in the apparatus shown in FIG. 7 or FIG. 8 are equivalent to at least one of the central processing unit 2111, the network processor 2132, and the network processor 2142 in the communication device 2100.

An embodiment of this application further provides a network device. The network device includes a processor. The processor is coupled to a memory, the memory stores at least one program instruction or code, and the at least one program instruction or code is loaded and executed by the processor, to enable the network device to implement any one of the foregoing data transmission methods.

An embodiment of this application further provides a data transmission system. The system includes a first module and a second module. For a method performed by the first module and the second module, refer to the related descriptions in the embodiment shown in FIG. 3. Details are not described herein again.

An embodiment of this application further provides a data transmission system. The system includes the apparatus shown in FIG. 7 and the apparatus shown in FIG. 8.

An embodiment of this application further provides a data transmission system. The system includes a first device and a second device. Optionally, the first device is the communication device 1500 shown in FIG. 9, the communication device 2000 shown in FIG. 10, or the communication device 2100 shown in FIG. 11, and the second device is the communication device 1500 shown in FIG. 9, the communication device 2000 shown in FIG. 10, or the communication device 2100 shown in FIG. 11.

For a method performed by the first device and the second device, refer to the related descriptions in the embodiment shown in FIG. 3. Details are not described herein again.

It should be understood that the foregoing processor may be a central processing unit (Central Processing Unit, CPU), or may be another general-purpose processor, a digital signal processor (digital signal processor, DSP), an application-specific integrated circuit (application-specific integrated circuit, ASIC), a field-programmable gate array (field-programmable gate array, FPGA) or another programmable logic device, a discrete gate or a transistor logic device, a discrete hardware component, or the like. The general-purpose processor may be a microprocessor, any conventional processor, or the like. It should be noted that the processor may be a processor that supports an advanced reduced instruction set computer machines (advanced RISC machines, ARM) architecture.

Further, in an optional embodiment, the memory may include a read-only memory and a random access memory, and provide instructions and data for the processor. The memory may further include a nonvolatile random access memory. For example, the memory may further store information about a device type.

The memory may be a volatile memory or a nonvolatile memory, or may include both the volatile memory and the nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example, and not limitation, many forms of RAMs may be used, for example, a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

A computer-readable storage medium is further provided. The storage medium stores at least one program instruction or code, and the program instruction or code is loaded and executed by a processor, to enable a computer to implement any one of the data transmission methods in FIG. 3.

This application provides a computer program (product). When the computer program is executed by a computer, a processor or a computer may be enabled to perform the corresponding steps and/or procedures in the foregoing method embodiments.

A chip is provided, and includes: a processor, configured to invoke, from a memory, instructions stored in a memory and run instructions, to enable a communication device on which the chip is installed to perform the methods in the foregoing aspects.

Another chip is provided, and includes an input interface, an output interface, a processor, and a memory. The input interface, the output interface, the processor, and the memory are connected through an internal connection path. The processor is configured to execute code in the memory. When the code is executed, the processor is configured to perform the methods in the foregoing aspects.

A communication device is further provided. The device includes the foregoing chip. For example, the device is a router, a switch, or a server.

All or some of the foregoing embodiments may be implemented by software, hardware, firmware, or any combination thereof. When software is used to implement the embodiments, all or some of the embodiments may be implemented in a form of a computer program product. The computer program product includes one or more computer instructions. When the computer program instructions are loaded and executed on a computer, the procedures or functions according to this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive Solid-State Drive), or the like.

In the foregoing specific implementations, the objectives, technical solutions, and beneficial effects of this application are further described in detail. It should be understood that the foregoing descriptions are merely specific implementations of this application, but are not intended to limit the protection scope of this application. Any modification, equivalent replacement, improvement, or the like made based on the technical solutions of this application shall fall within the protection scope of this application.

A person of ordinary skill in the art may be aware that, the method steps and modules described with reference to embodiments disclosed in this specification can be implemented by software, hardware, firmware, or any combination thereof. To clearly describe interchangeability between the hardware and the software, the steps and compositions of embodiments have been usually described in terms of functions in the foregoing descriptions. Whether the functions are performed by hardware or software depends on particular applications and design constraint conditions of the technical solutions. A person of ordinary skill in the art may use different methods to implement the described functions for each particular application, but it should not be considered that the implementation goes beyond the scope of this application.

A person of ordinary skill in the art may understand that all or some of the steps of embodiments may be implemented by hardware or a program instructing related hardware. The program may be stored in a computer-readable storage medium. The storage medium may include: a read-only memory, a magnetic disk, or an optical disc.

When software is used to implement the embodiments, all or some of the embodiments may be implemented in a form of a computer program product. The computer program product includes one or more computer program instructions. For example, the methods in embodiments of this application may be described in a context of a machine-executable instruction. For example, the machine-executable instructions are included in a program module that is in a device for execution on a real or virtual processor of a target. Usually, the program module includes a routine, a program, a library, an object, a class, a component, a data structure, and the like, and executes a specific task or implements a specific abstract data structure. In various embodiments, functions of the program modules may be combined or split between the described program modules. The machine-executable instruction for the program module may be executed locally or within a distributed device. In the distributed device, the program modules may be located in both a local storage medium and a remote storage medium.

Computer program code for implementing the methods in embodiments of this application may be written in one or more programming languages. The computer program code may be provided for a processor of a general-purpose computer, a dedicated computer, or another programmable data processing apparatus, so that when the program code is executed by the computer or the another programmable data processing apparatus, functions/operations specified in the flowcharts and/or block diagrams are implemented. The program code may be executed entirely on the computer, partially on the computer, as a standalone software package, partially on the computer and partially on a remote computer, or entirely on the remote computer or server.

In the context of embodiments of this application, the computer program code or related data may be carried in any appropriate carrier, so that the device, the apparatus, or the processor can perform various processing and operations described above. Examples of the carrier include a signal, a computer-readable medium, and the like.

Examples of the signal may include an electrical signal, an optical signal, a radio signal, a voice signal, or other forms of propagated signals, such as a carrier wave and an infrared signal.

The computer-readable medium may be any tangible medium that includes or stores a program used for or related to an instruction execution system, apparatus, or device. The machine-readable medium may be a machine-readable signal medium or a machine-readable storage medium. The machine-readable medium may include but is not limited to an electronic, magnetic, optical, electromagnetic, infrared, or semiconductor system, apparatus, or device, or any appropriate combination thereof. More detailed examples of the machine-readable storage medium include an electrical connection with one or more wires, a portable computer disk, a hard disk, a random access memory (RAM), a read-only memory (ROM), an erasable programmable read-only memory (EPROM or flash memory), an optical storage device, a magnetic storage device, or any appropriate combination thereof.

It may be clearly understood by a person skilled in the art that, for the purpose of convenient and brief description, for a detailed working process of the foregoing system, device, and module, refer to a corresponding process in the foregoing method embodiments. Details are not described herein again.

In several embodiments provided in this application, it should be understood that the disclosed system, device, and method may be implemented in other manners. For example, the described device embodiment is merely an example. For example, module division is merely logical function division and may be other division during actual implementation. For example, a plurality of modules or components may be combined or integrated into another system, or some features may be ignored or not performed. In addition, the displayed or discussed mutual couplings or direct couplings or communication connections may be indirect couplings or communication connections implemented through some interfaces, devices, or modules, or may be electrical, mechanical, or other forms of connections.

The modules described as separate components may or may not be physically separate, and components displayed as modules may or may not be physical modules, may be located in one position, or may be distributed on a plurality of network modules. Some or all of the modules may be selected based on an actual requirement to achieve the objectives of the solutions in embodiments of this application.

In addition, functional modules in embodiments of this application may be integrated into one processing module, or each of the modules may exist alone physically, or two or more modules may be integrated into one module. The integrated module may be implemented in a form of hardware, or may be implemented in a form of a software functional module.

When the integrated module is implemented in the form of the software functional module and sold or used as an independent product, the integrated module may be stored in a computer-readable storage medium. Based on such an understanding, the technical solutions of this application essentially, or the part contributing to the conventional technology, or all or some of the technical solutions may be implemented in a form of a software product. The computer software product is stored in a storage medium and includes several instructions for indicating a computer device (which may be a personal computer, a server, a network device, or the like) to perform all or some of the steps in the methods in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

In this application, terms such as "first" and "second" are used to distinguish between same or similar items that have basically same effects and functions. It should be understood that there is no logical or time sequence dependency between "first", "second", and "n^{th}", and neither a quantity nor an execution sequence is limited. It should be further understood that although the terms such as "first" and "second" are used in the following descriptions to describe various elements, these elements should not be limited by the terms. These terms are merely used to distinguish one element from another element. For example, without departing from a scope of the various examples, a first network device may be referred to as a second network device, and similarly, the second network device may be referred to as the first network device. The first network device and the second network device may be network devices of any type, and in some cases, may be separate and different network devices.

It should be further understood that sequence numbers of processes do not mean execution sequences in embodiments of this application. The execution sequences of the processes should be determined based on functions and internal logic of the processes, and should not be construed as any limitation on the implementation processes of embodiments of this application.

In this application, a term "at least one" means one or more, and a term "a plurality of" means two or more. For example, a plurality of second packets mean two or more second packets. The terms "system" and "network" are often used interchangeably in this specification.

It should be understood that the terms used in the descriptions of various examples in this specification are merely intended to describe specific examples, but are not intended to constitute a limitation. As used in the descriptions of the various examples and in the appended claims, singular forms "one ("a" or "an")" and "the" are intended to also include a plural form, unless otherwise explicitly indicated in the context.

It should be further understood that when being used in this specification, a term "include" (also referred to as "includes", "including", "comprises", and/or "comprising") specifies presence of stated features, integers, steps, operations, elements, and/or components, but does not preclude presence or addition of one or more other features, integers, steps, operations, elements, components, and/or groups thereof.

It should be further understood that a term "if" may be interpreted as a meaning of "when" ("when" or "upon"), "in response to determining", or "in response to detecting". Similarly, according to the context, a phrase "if it is determined that" or "if (a stated condition or event) is detected" may be interpreted as a meaning of "when it is determined that" or "in response to determining" or "when (the stated condition or event) is detected" or "in response to detecting (the stated condition or event)".

It should be understood that determining B based on A does not mean that B is determined based only on A, and B may alternatively be determined based on A and/or other information.

It should be further understood that "one embodiment", "an embodiment", or "a possible implementation" mentioned throughout this specification means that particular features, structures, or characteristics related to the embodiments or implementations are included in at least one embodiment of this application. Therefore, "in one embodiment", "in an embodiment", or "in a possible implementation" appearing throughout this specification does not necessarily mean a same embodiment. In addition, these particular features, structures, or characteristics may be combined in one or more embodiments in any appropriate manner.

## Claims

1. A data transmission method, wherein the method comprises:
obtaining first data, wherein the first data is obtained by encoding first reference data by using a first forward error correction FEC code;
encoding the first data by using a second FEC code, to obtain a first encoding result;
obtaining second data, wherein the second data comprises the first encoding result and padding data used to adjust a frequency, the padding data carries data transmission related information, and the padding data is data on which protection processing is performed; and
transmitting the second data.

2. The method according to claim 1, wherein the protection processing comprises adding cyclic redundancy check CRC, and the padding data is data to which protection of the CRC is added.

3. The method according to claim 1, wherein the protection processing comprises performing encoding by using a third FEC code, and the padding data is data encoded by using the third FEC code.

4. The method according to claim 1, wherein the protection processing comprises adding cyclic redundancy check CRC and performing encoding by using a third FEC code, and the padding data is data to which protection of the CRC is added and encoded by using the third FEC code.

5. The method according to claim 3 or 4, wherein the third FEC code is the same as the second FEC code.

6. The method according to any one of claims 1 to 5, wherein a length of the padding data is an integer multiple of a length of the second FEC code.

7. The method according to any one of claims 1 to 6, wherein obtaining the second data comprises:
inserting, into the first encoding result based on a reference density, the padding data used to adjust a frequency, to obtain the second data, wherein the reference density is determined based on overhead ratios of the first FEC code and the second FEC code and a frequency that is of a crystal oscillator and that is used when the first data is encoded by using the second FEC code.

8. The method according to any one of claims 1 to 7, wherein after transmitting the second data, the method further comprises:
obtaining at least one piece of third data, wherein the third data is obtained by encoding second reference data by using a fourth FEC code;
encoding any one of the at least one piece of third data by using a fifth FEC code, to obtain a second encoding result;
obtaining fourth data, wherein the fourth data comprises the second encoding result and the padding data; and
transmitting the fourth data.

9. A data transmission method, wherein the method comprises:
receiving second data, wherein the second data comprises a first encoding result and padding data used to adjust a frequency, the padding data carries data transmission related information, the padding data is data on which protection processing is performed, the first encoding result is obtained by encoding first data by using a second forward error correction FEC code, and the first data is obtained by encoding first reference data by using a first FEC code;
obtaining the first encoding result and the padding data from the second data;
decoding the first encoding result by using the second FEC code, to obtain the first data; and
obtaining the data transmission related information based on the padding data.

10. The method according to claim 9, wherein the protection processing comprises adding cyclic redundancy check CRC, and the padding data is data to which protection of the CRC is added; and
obtaining the data transmission related information based on the padding data comprises:
performing the CRC on the padding data, and obtaining the data transmission related information after the CRC succeeds.

11. The method according to claim 9, wherein the protection processing comprises performing encoding by using a third FEC code, and the padding data is data encoded by using the third FEC code; and
obtaining the data transmission related information based on the padding data comprises:
decoding the padding data by using the third FEC code, and obtaining the data transmission related information based on a decoding result.

12. The method according to claim 9, wherein the protection processing comprises adding cyclic redundancy check CRC and performing encoding by using a third FEC code, and the padding data is data to which protection of the CRC is added and encoded by using the third FEC code; and
obtaining the data transmission related information based on the padding data comprises:
decoding the padding data by using the third FEC code, performing the CRC on a decoding result, and obtaining the data transmission related information after the CRC succeeds.

13. The method according to claim 11 or 12, wherein the third FEC code is the same as the second FEC code.

14. The method according to any one of claims 9 to 13, wherein a length of the padding data is an integer multiple of a length of the second FEC code.

15. The method according to any one of claims 9 to 14, wherein the method further comprises:
receiving at least one piece of fourth data, wherein the fourth data comprises a second encoding result and padding data, the second encoding result is obtained by encoding third data by using a fifth FEC code, and the third data is obtained by encoding second reference data by using a fourth FEC code; and
obtaining the second encoding result and the padding data from each piece of fourth data; and decoding the second encoding result by using the fifth FEC code, to obtain the third data; and
obtaining the data transmission related information based on the padding data comprises:
comparing the padding data obtained from each piece of fourth data with the padding data obtained from the second data, and when it is determined, based on a comparison result, that an amount of same padding data reaches a threshold, obtaining the data transmission related information based on the padding data.

16. The method according to claim 15, wherein comparing the padding data obtained from each piece of fourth data with the padding data obtained from the second data comprises:
separately splitting the padding data obtained from each piece of fourth data and the padding data obtained from the second data, and comparing data blocks obtained through splitting.

17. A data transmission apparatus, wherein the apparatus comprises:
a first obtaining module, configured to obtain first data, wherein the first data is obtained by encoding first reference data by using a first forward error correction FEC code;
an encoding module, configured to encode the first data by using a second FEC code, to obtain a first encoding result;
a second obtaining module, configured to obtain second data, wherein the second data comprises the first encoding result and padding data used to adjust a frequency, the padding data carries data transmission related information, and the padding data is data on which protection processing is performed; and
a transmission module, configured to transmit the second data.

18. The apparatus according to claim 17, wherein the protection processing comprises adding cyclic redundancy check CRC, and the padding data is data to which protection of the CRC is added.

19. The apparatus according to claim 17, wherein the protection processing comprises performing encoding by using a third FEC code, and the padding data is data encoded by using the third FEC code.

20. The apparatus according to claim 17, wherein the protection processing comprises adding cyclic redundancy check CRC and performing encoding by using a third FEC code, and the padding data is data to which protection of the CRC is added and encoded by using the third FEC code.

21. The apparatus according to claim 19 or 20, wherein the third FEC code is the same as the second FEC code.

22. The apparatus according to any one of claims 17 to 21, wherein a length of the padding data is an integer multiple of a length of the second FEC code.

23. The apparatus according to any one of claims 17 to 22, wherein the second obtaining module is configured to insert, into the first encoding result based on a reference density, the padding data used to adjust a frequency, to obtain the second data, wherein the reference density is determined based on overhead ratios of the first FEC code and the second FEC code and a frequency that is of a crystal oscillator and that is used when the first data is encoded by using the second FEC code.

24. The apparatus according to any one of claims 17 to 23, wherein the first obtaining module is further configured to obtain at least one piece of third data, wherein the third data is obtained by encoding second reference data by using a fourth FEC code;
the encoding module is further configured to encode any one of the at least one piece of third data by using a fifth FEC code, to obtain a second encoding result;
the second obtaining module is further configured to obtain fourth data, wherein the fourth data comprises the second encoding result and the padding data; and
the transmission module is further configured to transmit the fourth data.

25. A data transmission apparatus, wherein the apparatus comprises:
a receiving module, configured to receive second data, wherein the second data comprises a first encoding result and padding data used to adjust a frequency, the padding data carries data transmission related information, the padding data is data on which protection processing is performed, the first encoding result is obtained by encoding first data by using a second forward error correction FEC code, and the first data is obtained by encoding first reference data by using a first FEC code;
a first obtaining module, configured to obtain the first encoding result and the padding data from the second data;
a decoding module, configured to decode the first encoding result by using the second FEC code, to obtain the first data; and
a second obtaining module, configured to obtain the data transmission related information based on the padding data.

26. The apparatus according to claim 25, wherein the protection processing comprises adding cyclic redundancy check CRC, and the padding data is data to which protection of the CRC is added; and
the second obtaining module is configured to: perform the CRC on the padding data, and obtain the data transmission related information after the CRC succeeds.

27. The apparatus according to claim 25, wherein the protection processing comprises performing encoding by using a third FEC code, and the padding data is data encoded by using the third FEC code; and
the second obtaining module is configured to: decode the padding data by using the third FEC code, and obtain the data transmission related information based on a decoding result.

28. The apparatus according to claim 25, wherein the protection processing comprises adding cyclic redundancy check CRC and performing encoding by using a third FEC code, and the padding data is data to which protection of the CRC is added and encoded by using the third FEC code; and
the second obtaining module is configured to: decode the padding data by using the third FEC code, perform the CRC on a decoding result, and obtain the data transmission related information after the CRC succeeds.

29. The apparatus according to claim 27 or 28, wherein the third FEC code is the same as the second FEC code.

30. The apparatus according to any one of claims 25 to 29, wherein a length of the padding data is an integer multiple of a length of the second FEC code.

31. The apparatus according to any one of claims 25 to 30, wherein the receiving module is further configured to receive at least one piece of fourth data, wherein the fourth data comprises a second encoding result and padding data, the second encoding result is obtained by encoding third data by using a fifth FEC code, and the third data is obtained by encoding second reference data by using a fourth FEC code;
the first obtaining module is further configured to obtain the second encoding result and the padding data from each piece of fourth data;
the decoding module is further configured to decode the second encoding result by using the fifth FEC code, to obtain the third data; and
the second obtaining module is configured to: compare the padding data obtained from each piece of fourth data with the padding data obtained from the second data, and when it is determined, based on a comparison result, that an amount of same padding data reaches a threshold, obtain the data transmission related information based on the padding data.

32. The apparatus according to claim 31, wherein the second obtaining module is configured to: separately split the padding data obtained from each piece of fourth data and the padding data obtained from the second data, and compare data blocks obtained through splitting.

33. A network device, wherein the network device comprises a processor, wherein the processor is coupled to a memory, the memory stores at least one program instruction or code, and the at least one program instruction or code is loaded and executed by the processor, to enable the network device to implement the method according to any one of claims 1 to 16.

34. A data transmission system, wherein the system comprises a first module and a second module, the first module is configured to perform the method according to any one of claims 1 to 8, and the second module is configured to perform the method according to any one of claims 9 to 16.

35. A computer-readable storage medium, wherein the storage medium stores at least one program instruction or code, and the program instruction or code is loaded and executed by a processor, to enable a computer to implement the method according to any one of claims 1 to 16.

36. A chip, wherein the chip comprises a processor, and the processor is configured to implement the method according to any one of claims 1 to 16.

37. A communication device, wherein the communication device comprises at least one chip according to claim 36.
